(19) **Europäisches Patentamt**
**European Patent Office**
**Office européen des brevets**

(11) **EP 4 644 919 A1**

(12) **EUROPÄISCHE PATENTANMELDUNG**

(43) Veröffentlichungstag:
05.11.2025  Patentblatt 2025/45

(21) Anmeldenummer: 24173405.2

(22) Anmeldetag: 30.04.2024

(51) Internationale Patentklassifikation (IPC):
*G01R 29/12* (2006.01)  *G01R 15/14* (2006.01)
*G01R 15/16* (2006.01)  *G01R 19/00* (2006.01)

(52) Gemeinsame Patentklassifikation (CPC):
**G01R 15/144; G01R 15/165; G01R 29/12;**
G01R 19/0084

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
• **Gashi, Indrit**
**81241 München (DE)**
• **Raab, Oliver**
**94496 Ortenburg (DE)**
• **Santos Wilke, Hans**
**85599 Parsdorf (DE)**
• **Weikert, Robert**
**92342 Burggriesbach (DE)**

(74) Vertreter: **Siemens Patent Attorneys**
**Postfach 22 16 34**
**80506 München (DE)**

(54) **VORRICHTUNG UND VERFAHREN ZUR BESTIMMUNG EINER ELEKTRISCHEN GRÖSSE EINES ZU VERMESSENDEN ELEKTRISCHEN LEITERS**

(57)  Es wird eine Vorrichtung und ein Verfahren zur berührungslosen Bestimmung einer elektrischen Größe eines zu vermessenden elektrischen Leiters (con) vorgeschlagen. Mit einer Anordnung von Messeinrichtung/en (D1, D2) mit wenigstens einem Dielektrikum ($\varepsilon_r$) an dem zu vermessenden elektrischen Leiter (con) werden zwei Messungen einer elektrischen Größe (D1, D2) vorgenommen. Durch die bekannte Größe, die das Dielektrikum mit seiner stoffspezifischen Permittivitätszahl und Dicke in die Vergleichsmessung einbringt, kann das ratiometrische Messprinzip angewendet werden und, unabhängig von Kenntnissen über den Abstand vom elektrischen Leiter (con), eine elektrische Größe, insbesondere die anliegende Spannung (U) genau bestimmt werden.

FIG 1

EP 4 644 919 A1

**Beschreibung**

Die Erfindung betrifft eine Vorrichtung umfassend wenigstens eine berührungslose Messeinrichtung zur Messung einer elektrischen Größe eines zu vermessenden elektrischen Leiters sowie ein Verfahren zur berührungslosen Messung und Bestimmung einer elektrischen Größe eines stromdurchflossenen elektrischen Leiters.

Die exakte Bestimmung elektrischer Größen wie elektrischer Strom, elektrische Spannung, elektrischer Energiefluss, ist eine wichtige Aufgabe für unterschiedliche Anwendungsfelder, beispielsweise in der industriellen Automatisierung, der Gebäudetechnik oder auch in großflächigen elektrischen Verteilernetzen. Insbesondere im Zuge der voranschreitenden Umstellung auf erneuerbare Energien und der Dezentralisierung der Energieerzeugung wird es in Zukunft von entscheidender Bedeutung sein, elektrische Größen von stromführenden Bauteilen exakt und örtlich aufgelöst abbilden zu können. Insbesondere in der industriellen Automatisierung, sei es in Schaltanlagen oder kleiner dimensioniert auf Leiterplatten wird es zunehmend wichtiger elektrische Größen von stromführenden Bauteilen zuverlässig bestimmen zu können.

Zur Durchführung von Strommessungen stehen bereits unterschiedliche Messverfahren zur Verfügung. Bekannt sind als berührungslose Messmethoden beispielsweise Hall-Sensoren oder Rogowski-Spulen. Auch im Bereich der Spannungsmessung sind bereits berührungslose Verfahren bekannt. Beispielsweise das Prinzip des Elektroskops oder das des Voltmeters, insbesondere der Einsatz eines mikroelektromechanischen Voltmeters, auch bezeichnet als mikroelektromechanische Feldmühle. Dieses Messprinzip beruht auf einer Messung der zeitlichen Veränderung einer elektrischen Kapazität mittels eines mikroelektromechanischen Systems. Die zeitliche Veränderung beziehungsweise die zeitlich veränderliche Abschattung der Kapazität wird mechanisch mit einem elektrischen, elektrostatischen oder thermischen Aktor herbeigeführt. Um die Veränderung der Kapazität zu messen, wird ein Verschiebungsstrom durch einen Strom-Spannungs-Wandler erfasst und hierdurch ein Messsignal generiert. Der Einfluss der zu messenden elektrischen Spannung auf das Messergebnis wird dadurch eliminiert, dass die Spannung konstante Teile enthält und der Strom-Spannungs-Wandler während der Schaltflanken der Spannung abgetastet wird. So kann eine Impulsantwort auf Spannungsänderungen der zu messenden Spannung, die auch auf den Messkondensator wirken, ausgeblendet werden.

Es wird also die Eigenschaft des kapazitiven Messprinzips genutzt, dass ein Signal nur detektiert werden kann, wenn sich am Kondensator Ladungen verschieben, die einen Verschiebungsstrom I von t initiieren. Hierfür gilt die Gleichung

$I(t) = dC/dt \cdot U + dU/dt \cdot C$, wobei C die Kapazität des Kondensators ist und U die am Kondensator anliegende Spannung. Die Kapazität des Kondensators, bzw. die Kapazität zwischen einem Messobjekt, beispielsweise einem stromführenden Leiter, und dem Sensor, insbesondere einem mikroelektromechanischen Voltmeter, kann durch Änderung der Fläche der Kondensatorplatten, insbesondere durch Einschieben von Blenden in den Kondensatorspalt, durch Änderung des Abstands der Kondensatorplatten oder durch Änderung der relativen Dielektrizitätskonstante des zwischen den Platten befindlichen Mediums geändert werden, was aus den Anmeldungsschriften DE102010035381A1 und DE102008052477A1 bekannt ist.

Waren bisherige bewehrte Spannungsmessungen in den meisten Fällen berührende Verfahren, beispielsweise mit einem Analog-Digital-Konverter, kann mittels einer Feldmühle ein berührungsloses Verfahren realisiert werden.

Berührendes Verfahren heißt, dass ein physischer Kontakt zum Messobjekt hergestellt werden muss, um eine direkte Messung im Stromkreis vorzunehmen. Hierzu muss also eine Messvorrichtung entweder fest integriert sein oder alternativ die Isolation der zu messenden elektrischen Leitung unterbrochen, d. h. beschädigt werden. Dieser notwendige direkte physische Kontakt zur stromführenden Leitung hat insbesondere bei bereits bestehenden Anlagen ("Brownfield") den Nachteil, dass diese Verfahren zur Vornahme einer Messung oder zur Installation zwischenzeitlich vom Netz getrennt werden müssen und im späteren Betrieb strenge Sicherheitsanforderungen eingehalten werden müssen, was die elektrische Sicherheit betrifft. Auch für die Datenübertragung muss eine galvanische Trennung realisiert werden. Unter einem berührungslosen Verfahren wird ein Verfahren bzw. eine Vorrichtung angesehen oder verstanden, welche mit dem zu vermessenden elektrischen Leiter galvanisch getrennt angeordnet ist. Das heißt die Messung an dem elektrischen Leiter wird dadurch vorgenommen, dass das elektrische Feld oder das elektromagnetische Feld, welches vom stromdurchflossenen Leiter ausgeht, mittels eines Sensors erfasst wird. Unter galvanisch getrennt ist also zu verstehen, dass es zwar eine Potentialauswirkung gibt, also dass das elektrische Feld oder ein elektromagnetisches Feld von einem Sensor erfasst werden kann, aber es liegt eine elektrische Isolation vor, so dass kein Strom zwischen der zu vermessenden Leiter und der Vorrichtung, insbesondere der Messvorrichtung, fließen kann.

Derartige berührungslose Messverfahren sind von großem Vorteil für den Einsatz in bestehenden Systemen, weil diese ohne baulichen Eingriff mit einer Messvorrichtung nachgerüstet werden können. Eine Schwierigkeit dieser berührungslosen Messung jedoch liegt darin, dass bei Messungen nur einer elektrischen Größe, beispielsweise der elektrischen Feldstärke, der Abstand der Messposition also des Sensors zum Messbereich des zu vermessenden elektrischen Leiters höchstgenau sein muss und ebenso exakt reproduzierbar sein muss. Diese Notwendigkeit stellt hohe Anforderungen an mechanische Realisierungen und Einbautoleranzen.

Ausgehend vom zuvor beschriebenen Stand der Technik liegt der Erfindung die Aufgabe zugrunde ein verbessertes Verfahren sowie eine verbesserte Vorrichtung zur berührungslosen Bestimmung einer elektrischen Größe anzugeben.

Diese Aufgabe wird durch die Merkmale des unabhängigen Patentanspruchs 1 gelöst. Die auf das Verfahren bezogene Aufgabe wird durch die Merkmale des Patentanspruchs 12 gelöst. Vorteile und Ausgestaltungen der Erfindung, die einzeln oder in Kombination miteinander einsetzbar sind, sind Gegenstand der Unteransprüche.

Die erfindungsgemäße Vorrichtung umfasst wenigstens eine Messeinrichtung zur Messung einer elektrischen Größe eines zu vermessenden elektrischen Leiters, wobei die Messeinrichtung an dem zu vermessendem elektrischem Leiter galvanisch getrennt zu diesem positionierbar ist. Die erfindungsgemäße Vorrichtung zeichnet sich dadurch aus, dass die wenigstens eine Messeinrichtung mit einem Dielektrikum einer bekannten Dicke angeordnet ist, sodass zwei Messungen der elektrischen Größe des zu vermessenden Leiters mit unterschiedlicher Permittivität zwischen Messeinrichtung und Leiter vornehmbar sind. Des Weiteren umfasst die erfindungsgemäße Vorrichtung eine Messsignalverarbeitungseinrichtung, welche ausgestaltet ist, aus den Messungen eine weitere elektrische Größe zu bestimmen.

Mittels einer derartigen Vorrichtung wird also eine abstandsunabhängige Ermittlung, einer eigentlich abstandsabhängigen elektrischen Größe realisiert. Als abstandsabhängige elektrische Größe seien alle elektrischen Größen gemeint, für deren Bestimmung eine Kenntnis über den genauen Abstand von elektrischem Leiter zur Messeinrichtung bzw. Messelektrode oder Messsensor nötig wäre. Insbesondere kann es sich um eine Spannungsermittlung handeln. Diese wäre durch die erfindungsgemäße Vorrichtung möglich, ohne den exakten Abstand von Leiter zur Messeinrichtung zu kennen.

Die erfindungsgemäße Vorrichtung hat zudem den Vorteil aller berührungslosen Messeinrichtungen, nämlich dass sie relativ leicht und ohne baulichen Aufwand und ohne großen Kostenaufwand nachrüstbar ist. Bisher mussten Anlagen spannungsfrei geschaltet werden und die Spannungsmessung der mit zu vermessenden Leitung verdrahtet werden, insbesondere in der Anwendung von Schaltschränken kann die Vorrichtung vorteilhaft eingesetzt werden, ohne dass eine Verdrahtung mit der Spannungsschiene notwendig ist.

Genutzt wird das ratiometrische Messprinzip. Das ratiometrische Messprinzip ist ein Verfahren zur Messung einer physikalischen Größe, bei dem die Ausgangsspannung oder der Ausgangswert des Sensors im Verhältnis zu einer Referenzspannung oder einem Referenzwert gemessen wird. Bei diesem Prinzip wird die gemessene Größe in Bezug zu einem festgelegten Bezugswert angegeben, anstatt einen absoluten Wert zu liefern. Dies hat den Vorteil, dass Schwankungen der Versorgungsspannung oder des Umgebungseinflusses minimiert werden können, da sie sowohl den Messwert als auch die Referenzspannung gleichermaßen beeinflussen. Dadurch wird die Genauigkeit und Zuverlässigkeit der Messung verbessert.

So kann, durch zweimalige Messung, entweder durch zwei Sensoren oder durch einen beweglichen Sensor an zwei Messpositionen oder, wie in diesem Fall mittels eines Sensors und eines durch ein Dielektrikum beeinflussten Abstandsbereichs zwischen Sensor und Leiter, ohne den genauen Abstand zu kennen, die Messgröße ermittelt werden. Mittels Anordnung des Dielektrikums im Abstand zwischen Sensor und zu messendem Leiter wird die relative Permittivität in diesem Bereich verändert. Permittivität sowie Dicke des Dielektrikums sind bekannt und können absolut genau gemessen werden und in die Bestimmung der weiteren Größe mit einfließen. Die Bestimmung von Dicke eines Dielektrikums und dessen relativer Permittivität ist mit viel höherer Genauigkeit möglich als eine mechanische Abstandspositionierung. Der Ansatz über unterschiedliche Sensorpositionen zu gehen, hat gegenüber der Lösung mit dem Dielektrikum insbesondere den Nachteil, dass auch hier eine mechanische Positionierung zweier Sensoren nötig ist und auch deren relativer Abstand zueinander mit einer wesentlich höheren Ungenauigkeit versehen ist als die Messung einer Dielektrikumsschichtdicke.

Geht man davon aus, dass im Grundzustand lediglich das Medium Luft zwischen dem zu vermessendem Leiter und den Sensoren vorliegt, insbesondere den Sensorflächen, beträgt die relative Permittivität $\varepsilon_r$ näherungsweise 1. Für eine ratiometrische Bestimmung einer elektrischen Größe sollten daher mindestens zwei Messungen mit verschiedenen relativen Permittivitäten $\varepsilon_r$ durchgeführt werden. Erfindungsgemäß wird dies mittels eines Dielektrikums realisiert, welches in den Abstand zum Leiter eingeschoben wird. Die relative Permittivität $\varepsilon_r$ des Dielektrikums beträgt dabei zweckdienlicherweise einen höheren Wert als die des Mediums Luft.

In einer vorteilhaften Ausführungsform der Erfindung umfasst die Vorrichtung eine Messeinrichtung, welche einen Sensor zur Messung einer elektrischen Feldstärke umfasst. Die Messung elektrischer Feldstärken kann dazu genutzt werden die am elektrischen Leiter anliegende elektrische Spannung zu bestimmen.

Besonders vorteilhaft ist die Ausführung der erfindungsgemäßen Vorrichtung mit einem als mikroelektromechanischen Voltmeter ausgestalteten Sensor. Die grundsätzliche Funktionsweise des mikroelektromechanischen Voltmeters wurde bereits beschrieben. Eingesetzt in einer erfindungsgemäßen Vorrichtung zur Erfassung der elektrischen Feldstärke kann es alle Vorteile, insbesondere die geringe bauliche Größe, die Messgenauigkeit, sowie die Messempfindlichkeit, darbieten.

Zweckdienlicherweise ist zumindest eine elektromagnetische Feldabschirmung umfasst, welche die Messeinrichtung bzw. die Messelektroden vor externen elektromagnetischen Feldern abschirmt.

Besonders auf die elektrische Feldstärke als Messgröße, wirkt eine Vielzahl an Störvariablen ein. Es müssen technische Maßnahmen ergriffen werden, um den Einfluss der Störvariablen zu minimieren. Ein Beispiel für diese variablen Störgrößen ist, dass bei einer elektrischen Feldmessung der Abstand zum zu messenden Leiter direkt in das Messsignal mit eingeht. Aber auch andere Effekte, wie die geometrische Ausrichtung des Leiters zu den Sensoren oder externe Störfelder, führen zu fehlerbehafteten, unpräzisen Messungen. Demnach werden die Messvorrichtungen, insbesondere die Messelektroden gegen externe Störgrößen entsprechend abgeschirmt.

In einer weiteren vorteilhaften Ausführungsform der erfindungsgemäßen Vorrichtung umfasst die Signalverarbeitungseinrichtung eine Auswerteelektronik. Insbesondere ist von der Auswerteelektronik eine Rechenlogik umfasst, welche zur Ausgabe digitaler Werte geeignet ist.

Beispielsweise ermittelt die Rechenlogik aus den gemessenen elektrischen Feldwerten die zu bestimmende Größe der elektrischen Spannung.

Bevorzugt umfasst die erfindungsgemäße Vorrichtung bzw. die Messsignalverarbeitungseinrichtung eine Signalaufbereitung. Unter Signalaufbereitung ist beispielsweise eine Signalverstärkung zu verstehen. Insbesondere bei mikroelektromechanischen Bauteilen ist eine Signalverstärkung wichtig. Die Signalaufbereitungsvorrichtung muss je Sensor vorgesehen sein. Bei mehreren Sensoren ist jede zweckdienlicher Weise einer Signalaufbereitungsvorrichtung zugeordnet. Die Auswerteelektronik wertet dann die Messsignale aller Sensoren aus und bestimmt daraus den gewünschten Wert.

Die Vornahme zweier Messungen mit unterschiedlicher relativer Permittivität im Messabstand wird bevorzug mittels einer Vorrichtung realisiert, in welcher eine erste Messeinrichtung mit einer zweiten Messeinrichtung so nebeneinander angeordnet ist, dass beide denselben Abstand zum zu vermessenden Leiter aufweisen sowie beide elektrisch auf demselben Potential liegen. Dies hat den Vorteil, die beweglichen Bauteile zu minimieren. Die Realisierung einer derartigen Anordnung ist relativ einfach auf einer Leiterplatte möglich, auf der beide Sensoren unmittelbar nebeneinander angeordnet vorliegen können. Einer der beiden Sensoren ist dann dabei mit einer Dielektrikumsschicht versehen. Das heißt beide Messsensoren können gleichzeitig die Messung vornehmen, liegen auf demselben Bezugspotential und haben denselben Abstand. Die Dielektrikumsschichtdicke $d_\varepsilon$ sowie die relative Permittivität $\varepsilon_r$ des Dielektrikums sind bekannt, womit sich die zu messende Größe unabhängig vom Positionierungsabstand der Vorrichtung zum zu vermessenden Leiter bestimmen lässt.

In einer alternativen Variante der erfindungsgemäßen Vorrichtung wird nur eine Messeinrichtung verwendet, welche beweglich angeordnet ist und somit einmal neben dem Dielektrikum mit nur Luft zwischen Messelektrode und elektrischem Leiter und einmal vom Dielektrikum abgeschirmt und somit veränderter Permittivität im Messabstand die Messung vornimmt.

In einer weiteren alternativen Ausführungsform der erfindungsgemäßen Vorrichtung umfasst die Messeinrichtung ein bewegliches Dielektrikum, welches einmal über die Messeinrichtung also in den Messabstand hinein bewegt werden kann oder aus dem Messabstand heraus bewegt werden kann, sodass mittels der einen Messeinrichtung zwei Messungen mit und ohne Dielektrikum vorgenommen werden können. Die Variante mit dem beweglich angeordneten Dielektrikum hat den Vorteil vieler Variationsmöglichkeiten, beispielweise auch mit unterschiedlichen Dielektrika zur Optimierung des Permittivitätsunterschieds. Insbesondere ist eine Integration des Dielektrikums direkt in das mikroelektromechanische Voltmeter möglich.

In einer weiteren vorteilhaften Ausgestaltung der erfindungsgemäßen Vorrichtung kann ein Dielektrikum vorgesehen sein, welches magnetisch beeinflussbar ist, mechanisch beeinflussbar ist, elektrostatisch beeinflussbar ist, thermisch beeinflussbar ist, optisch oder fluidisch beeinflussbar ist. Dies kann bedeuten, dass beispielsweise keine reine Dielektrikumsschicht sondern ein Dielektrikumsmaterial, welches in einen Festkörper eingebracht ist, verwendet wird. Alternativ können dielektrische Flüssigkeiten verwendet werden, die gekapselt in das Bauteil eingebracht werden. Ein Vorteil dielektrischer Flüssigkeiten liegt z. B. darin, dass deren relative Permittivität $\varepsilon_r$ gezielt beeinflusst werden kann.

In einer weiteren vorteilhaften Ausführungsform der erfindungsgemäßen Vorrichtung sind zwei Dielektrika umfasst, wobei das erste Dielektrikum ein High-k-Dielektrikum und das zweite Dielektrikum ein Low-k-Dielektrikum ist. Beide Dielektrika werden über jeweils einer Messvorrichtung angebracht oder derart nebeneinander angebracht, dass eine Messeinrichtung beweglich zwischen den beiden unterschiedlichen Dielektrika positioniert werden kann. Unter einem High-k-Dielektrikum ist ein Dielektrikum zu verstehen mit einer relativen Permittivität $\varepsilon_r > 3,9$ und unter einem Low-k-Dielektrikum ist ein Dielektrikum mit einer relativen Permittivität $\varepsilon_r < 3,9$ zu verstehen, insbesondere $\varepsilon_r < 2,4$. Eine derartige Vorrichtung mit zwei unterschiedlichen Dielektrika erhöht noch einmal die Messgenauigkeit bzw. die Genauigkeit der Bestimmung der elektrischen Größe aus den gemessenen Werten.

In dem erfindungsgemäßen Verfahren zur Bestimmung einer elektrischen Größe eines stromdurchflossenen elektrischen Leiters wird eine Vorrichtung entsprechend der ausgeführten erfindungsgemäßen Vorrichtung mit einem zu vermessenden elektrischen Leiter galvanisch getrennt angeordnet. Es wird eine erste und eine zweite Messung vorgenommen und es wird in einem Messsignalverarbeitungsschritt aus den Messwerten von erster und zweiter Messung eine weitere elektrische Größe ermittelt.

Die zweite Messung wird dabei also so vorgenommen, dass sie einen durch das Dielektrikum bewirkt unterschiedlichen Wert aufnimmt, welcher dann dazu beiträgt aufgrund der bekannten unterschiedlichen Permittivitäten den ansonsten relevanten Messabstand aus der Bestimmung der elektrischen Größe herauszukürzen.

Zweckdienlicherweise wird also in dem erfindungsgemäßen Verfahren in dem Messsignalverarbeitungsschritt die Bestimmung der weiteren elektrischen Größe nach einem ratiometrischen Prinzip vorgenommen. Dies hat den großen Vorteil, dass das Verfahren unabhängig vom Abstand ist bzw. nicht auf eine genaue Kenntnis des Abstands angewiesen ist. Auch muss für eine erneute Messung der Abstand nicht reproduzierbar sein.

Besonders bevorzugt wird in dem Verfahren mittels der ersten und zweiten Messung je eine elektrische Flussdichte $D_1$ und $D_2$ erfasst und im Messsignalverarbeitungsschritt die am zu vermessenden elektrischen Leiter anliegende Spannung U bestimmt. Diese wird folgendermaßen ermittelt:

$$U = \frac{D}{\varepsilon_0} \cdot d_0 + \frac{D}{\varepsilon_0 \varepsilon_r} \cdot d_\varepsilon$$

Dabei beschreibt $\varepsilon_r$, die relative Permittivität bzw. die stoffabhängige Permittivitätszahl des Dielektrikums. $\varepsilon_{r,\,Air} = 1$ steht für die stoffabhängige Permittivitätszahl von Luft. Die Permittivität $\varepsilon = \varepsilon_0 \bullet \varepsilon_r$ ermittelt sich aus der stoffabhängigen Permittivitätszahl und der elektrischen Feldkonstante $\varepsilon_0$.

$$U = \frac{D_1 D_2}{D_1 - D_2} \cdot \left( \frac{1}{\varepsilon_{r,dielect}} - \frac{1}{\varepsilon_{r,air}} \right) \frac{1}{\varepsilon_0} \cdot d_\varepsilon = \frac{D_1 D_2}{D_1 - D_2} \cdot \frac{1 - \varepsilon_r}{\varepsilon_0 \varepsilon_r} \cdot d_\varepsilon \, .$$

Diese entspricht der Permittivität des Vakuums. Durch die angegebenen Formeln wird ersichtlich, wie mittels der unterschiedlichen relativen Permittivitäten der beiden Messungen sich die Abhängigkeit von do also vom Abstand der Messsensorik zum zu vermessenden Leiter aufhebt. In einer weiteren vorteilhaften Ausführungsform des erfindungsgemäßen Verfahrens wird die Messung der elektrischen Flussdichte derart vorgenommen, dass mittels eines geerdeten Shutters wiederholt eine Sensorelektrodenanordnung von dem zu messenden Feld abgeschirmt und wieder dem Feld ausgesetzt wird, sodass die Sensorelektrodenanordnung hinter dem Shutter durch Influenz des zu messenden elektrischen Feldes abwechselnd ent- und aufgeladen wird.

Dies beschreibt im Wesentlichen die Funktionsweise des bevorzugt eingesetzten mikroelektromechanischen Voltmeters. Dies zeigt ebenso, wie die für eine Ausführungsform der Vorrichtung angegebene Variante, die Dielektrika in die Messsensorik zu integrieren, aussehen kann. Beispielsweise kann ein Shutter unterschiedlicher Permittivität verwendet werden unterschiedlich zu einem Shutter eines benachbarten

Voltmeters. Auch ein Aufbau mit Shuttern aus zwei Teilbereichen mit unterschiedlichen dielektrischen Eigenschaften kann die erfindungsgemäße Vorrichtung realisieren.

Weitere Merkmale, Eigenschaften und Vorteile der vorliegenden Erfindung ergeben sich aus der nachfolgenden Beschreibung unter Bezugnahme auf die beiden Figuren. Darin zeigen schematisch:

Figur 1     eine Seitenansicht auf zu vermessenden Leiter und Vorrichtung,

Figur 2     die Seitenansicht mit beweglichem Dielektrikum über zwei Sensoranordnungen,

Figur 3     die Anordnung unterschiedlicher Dielektrika über den Sensorelektroden,

Figur 4     eine erfindungsgemäße Variante mit beeinflussbarem Dielektrikum,

Figur 5     die Variante mit einem Dielektrikum als Shutter,

Figur 6     eine Draufsicht auf Kondensatorelektrodenpaare mit statisch angeordnetem Dielektrikum,

Figur 7     eine Draufsicht auf Kondensatorelektrodenpaare mit im Shutter integriertem Dielektrikum.

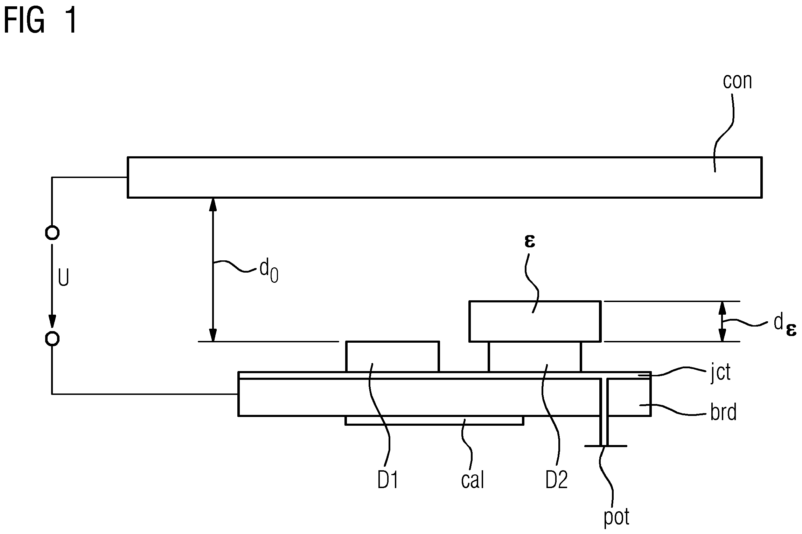

In den Ausführungsbeispielen und Figuren 1 bis 7 können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein. Auch wenn die Erfindung im Detail durch die Ausführungsbeispiele näher illustriert und beschrieben wird, ist die Erfindung nicht durch die offenbarten Beispiele eingeschränkt. Variationen hiervon können vom Fachmann abgeleitet werden, ohne den Schutz und Zwang der Erfindung, wie er durch die nachfolgenden Patentansprüche definiert wird, zu verlassen.

In der Figur 1 ist zunächst schematisch die Anordnung von zu messendem Leiters con mit der Vorrichtung gezeigt. Es soll beispielsweise die Spannung U bestimmt werden. Die Vorrichtung bzw. deren Sensoren $D_1$ und $D_2$ sind in einem Abstand do zum Leiter con angeordnet, der nicht bekannt ist. Die Sensoren $D_1$ und $D_2$ können beispielsweise elektromagnetische bzw. elektrische Feldsensoren sein, insbesondere mikroelektromechanische Feldmühlen. In der Figur 1 ist das Beispiel gezeigt, in dem die beiden Sensoren $D_1$ und $D_2$ auf gemeinsamen Potential pot liegen, welches als Bezugspotential z. B. geerdet sein kann. Eine derartige Anordnung kann relativ einfach auf einer Leiterplatte brd realisiert sein. Diese weist eine elektrisch leitfähige Kupferschicht jct auf, mit der die beiden Sensoren $D_1$ und $D_2$ elektrisch verbunden sind. Während der erste Sensor D, direkt dem elektrischen Feld des Leiters con ausgesetzt ist, befindet sich zwischen dem Sensor $D_2$ und dem zu messenden elektrischen Leiter con ein Dielektrikum mit bekannter relativer Permittivität $\varepsilon_r$ und bekannter Dicke $d_\varepsilon$. Die Variante mit zwei Messsensoren $D_1$ und $D_2$ hat den Vorteil, dass die Messung bzw. Bestimmung der elektrischen Größe nicht davon abhängig ist, dass zwischen den zwei Messungen keine Potentialveränderung am zu vermessenden Leiter con erfolgt.

Ein E-Feld-Sensor D1 bestimmt zunächst das elektrisches Feld eines elektrischen Leiters con durch Verschiebeströme auf zwei Sensorflächen. Diese sind direkt proportional zu dem elektrischen Feld beziehungsweise der Spannung U des zu vermessenden Leiters con. Die Messgröße Strom I ist abhängig von den Ladungsträgern Q und der Zeit $t$ zu:

$$I = \frac{\Delta Q}{\Delta t} .$$

Die Zeit ist fix durch die Bauweise des E-Feld-Sensors vorgegeben. Q dagegen ist abhängig von der Kapazität C zwischen Sensorfläche und der Spannung U des zu vermessenden Leiters:

$$Q = C \cdot U .$$

Die Kapazität C wiederum bestimmt sich in einer vereinfachten Anschauung aus der Fläche der Sensorflächen A, dem Abstand d zwischen Sensorfläche und dem zu vermessenden Leiter ssowie der Permittivität $\varepsilon = \varepsilon_0 \varepsilon_r$ zu:

$$C = \frac{\varepsilon_0 \varepsilon_r \cdot A}{d} .$$

Will man also die Empfindlichkeit des Messprinzips variieren, sind dies die möglichen Variablen. Das Messprinzip des E-Feld-Sensors basiert auf der zeitlichen Änderung der Fläche des dem Feld des zu vermessenden Leiters ausgesetzten A:

$$I(t) = U \frac{\varepsilon_0 \varepsilon_r}{d} \frac{dA}{dt}$$

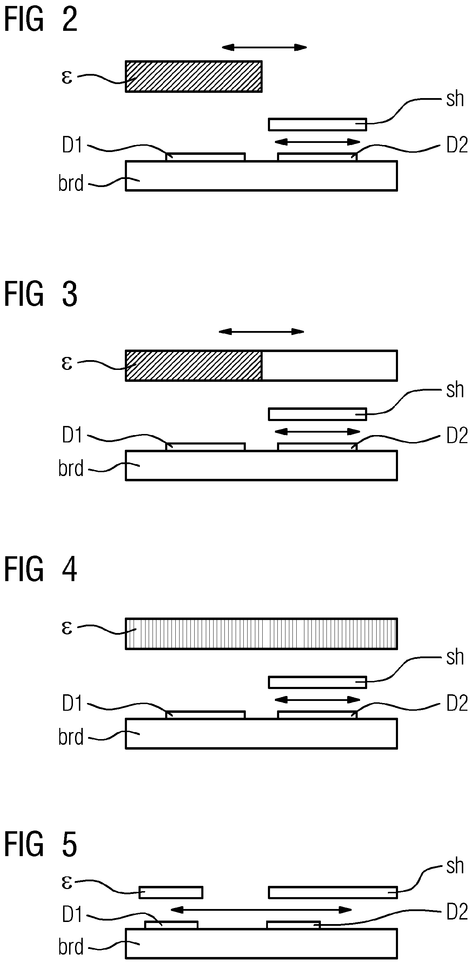

In den Figuren 2 bis 5 sind stark vereinfacht Seitenansichten der Messsensoren $D_1$ und $D_2$ gezeigt, jeweils von zwei fest installierten Messsensoren $D_1$ und $D_2$ auf gemeinsamer Leiterplatte brd und gemeinsamen Potential, wie in Figur 1 dargestellt. Darüber ist die Shutterblende sh der mikroelektromechanischen Feldmühle und mittels eines Doppelpfeils deren Bewegung angezeigt. Darüber wiederum sind unterschiedliche Ausführungen des Dielektrikums gezeigt.

In Figur 2 ist ein beweglich angeordnetes Dielektrikum gezeigt, welches im Wechsel über die unterschiedlichen Sensoranordnungen $D_1$ und $D_2$ bewegt wird.

In Figur 3 ist eine Variante mit zwei Dielektrika unterschiedlicher Permittivität $\varepsilon_r$ gezeigt. In Figur 4 ist angedeutet, dass die relative Permittivität $\varepsilon_r$ des Dielektrikums im Messverfahren beeinflussbar, also variierbar ist. Eine derartige Veränderung der Permittivität $\varepsilon_r$ kann besonders vorteilhaft bei dielektrischen Flüssigkeiten erfolgen, beispielsweise durch magnetisches, mechanisches, thermisches oder optisches Einwirken. Eine dielektrische Flüssigkeit würde in der vorliegenden Erfindung gekapselt vorliegen.

In Figur 5 ist schließlich noch die Variante gezeigt, dass das Dielektrikum direkt in der elektrischen Feldmühle, z. B. als Teil der Shutterblende sh oder alternativ zur Shutterblende sh selbst als Shutter sh eingesetzt wird.

Es kann also zwischen Ausführungen unterschieden werden, welche mit zwei Sensoren $D_1$ und $D_2$ arbeiten und solchen, welche nur mit einem Sensor $D_1$ arbeiten. Es kann ein Dielektrikum geben, oder verschiedene Dielektrika unterschiedlicher relativer Permittivität $\varepsilon_r$. Es kann Dielektrika mit dynamisch variabler Permittivität $\varepsilon_r$ geben. Prinzipiell wird ein Dielektrikum statisch oder beweglich in den Abstand do zwischen Voltmeter $D_1$ und zu messendem elektrischem Leiter con eingefügt oder entnommen.

Ist die Frequenz des Shutters sh deutlich geringer als die der Feldmühle und abgestimmt mit dem Messintervall der Auswertelogik cal, kann das ratiometrische Prinzip kontinuierlich angewendet werden. Auch eine Variante, in Anlehnung an Figur 5 so erläutert, dass ein dreigeteilter Shutter sh eingesetzt wird, kann von Vorteil sein. Ein Teil der Shutterfläche besteht dann beispielsweise aus einem Material mit hoher relativer Permittivität $\varepsilon_r>3,9$, also einem High-k-Dielektrikum. Ein weiterer Teil ist für das E-Feld durchlässig und ein dritter Teil besteht aus einem Material mit einem Low-k-Dielektrikum $\varepsilon_r<3,9$ oder sogar einem leitfähigen Material. Durch einen derartigen Aufbau bekommt man bei einem Schwingvorgang zwei unterschiedliche elektrische Feldstärken gemessen und kann dadurch wieder das ratiometrische Prinzip anwenden.

Für die beispielhafte Berechnung werden einige vereinfachende Annahmen getroffen. Es wird angenommen, dass die Potential-Flächen, zwischen denen der Sensor liegt, eben und viel größer sind als die Sensorflächen. Dies soll auch für die Fläche des Dielektrikums gelten. Zudem soll die Sensorfläche möglichst mittig in Bezug zu den genannten Flächen liegen.

Für die Kapazitäten der zwei Sensoren gilt:

$$C_1 = \frac{\varepsilon_0 A}{\frac{d_0}{\varepsilon_{r,air}}} \; , \; C_2 = \frac{\varepsilon_0 A}{\frac{d_0-d_\varepsilon}{\varepsilon_{r,air}}+\frac{d_\varepsilon}{\varepsilon_{r,dielect}}} \; .$$

Die relative Permittivität der Luft $\varepsilon_{r,air}$ setzen wir im Folgenden zu 1 und nennen die relative Permittivität $\varepsilon_{r,dielect}$ nur noch $\varepsilon_r$.

Für physikalische Messgröße ist der Verschiebestrom I, für welchen für die Sensoren 1 und 2 gilt:

$$I_1 = \frac{C_1}{\Delta t} U \quad \text{und} \quad I_2 = \frac{C_2}{\Delta t} U \; .$$

Durch Umstellen und Einsetzen kürzt sich der unbekannte Abstand $d_0$ raus und es kann die Spannung U bestimmt werden zu:

$$U = \frac{\Delta t \sqrt{\varepsilon_r^2(4\, I_1 I_2 \varepsilon_0 A+1)-2\varepsilon_r+1}+\varepsilon_r-1}{2\varepsilon_0 \varepsilon_r A} \; .$$

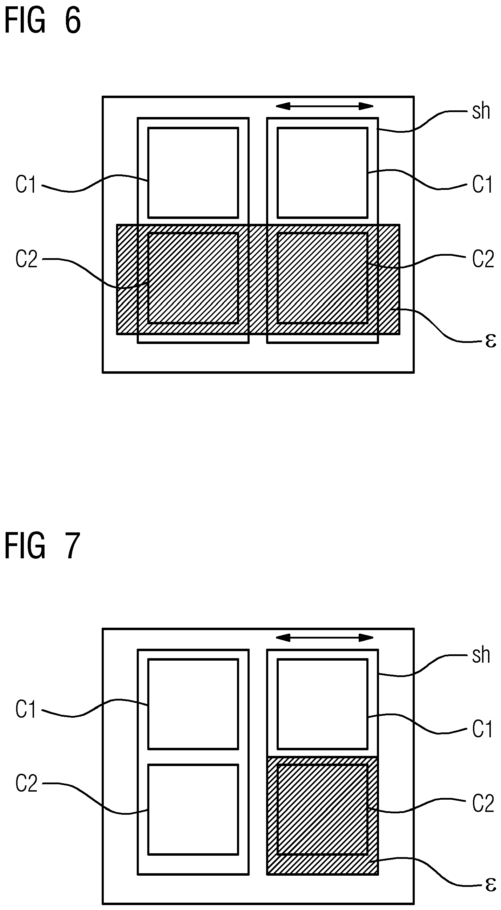

Die Figuren 6 und 7 zeigen Draufsichten auf Leiterplatten brd und die darauf angeordneten Sensoren $D_1$ und $D_2$ bzw. Sensorelektroden, welche bevorzugt als Kondensatorpaare $C_1$ und $C_2$ auf dem gleichen Chip brd angeordnet sind. Jedes zusammengehörige Kondensatorpaar $C_1$ und $C_2$ ist mit einem anderen Dielektrikum ausgestattet. Die Dielektrika können analog zum Aufbau aus den Figuren 2 bis 5 räumlich über der schwingenden Shutterblende sh angeordnet werden. Sie müssen jedoch aufgrund der doppelten Anordnung der Kondensatoren $C_1$ und $C_2$ nicht beweglich ausgestattet werden. Die Anwendung des ratiometrischen Prinzips erfolgt anschließend in der Signalverarbeitungseinheit cal des Sensors durch den Vergleich der Messung mit Dielektrikum zu der ohne.

In Figur 6 ist beispielsweise gezeigt, dass der Shutter sh von links nach rechts schwingt, dabei bedeckt er entweder die jeweils ersten Elektroden der Elektrodenpaare $C_1$ und $C_2$ und danach die zweiten Elektroden der Elektrodenpaare $C_1$ und $C_2$. Das Dielektrikum ist statisch über den Elektroden des Elektrodenpaars $C_2$ angeordnet.

In der Figur 7 schließlich ist noch gezeigt, dass wiederum zwei Elektrodenpaare $C_1$ und $C_2$ auf einem gemeinsamen Chip brd fest angeordnet sind. Der Shutter sh schwingt wieder von links nach rechts, bedeckt zunächst die ersten Elektroden der Elektrodenpaare $C_1$ und $C_2$, dann die zweiten Elektroden der Elektrodenpaare $C_1$ und $C_2$. Der Shutter sh weist dabei zwei Teilbereiche auf. Die unterschiedlichen Teilbereiche weisen unterschiedliche dielektrische Eigenschaften auf. Insbesondere sind diese Anordnungen auf beliebig viele Kondensatorpaare ausweitbar. Die vorgeschlagenen Lösungen beinhalten alle eine Variation der relativen Permittivität $\varepsilon_r$ im Messabstand $d_0$ zwischen Sensorik $D_1$ und $D_2$ und zu messendem elektrischem Leiter con, insbesondere zwischen mikroelektromechanischem Voltmeter und spannungsführenden elektrischen Leiter con. In allen Fällen bleibt der Abstand do stabil, was von ganz besonderem Vorteil bei Messsystemen und kleinem Messabstand $d_0$ ist, auf den die Messwerte besonders empfindlich reagieren.

Zusammenfassend kann festgehalten werden: Es wird eine Vorrichtung und ein Verfahren zur berührungslosen Bestimmung einer elektrischen Größe eines zu vermessenden elektrischen Leiters con vorgeschlagen. Mit einer Anordnung von Messeinrichtung/en D1, D2 mit wenigstens einem Dielektrikum $\varepsilon_r$ an dem zu vermessenden elektrischen Leiter con werden zwei Messungen einer elektrischen Größe D1, D2 vorgenommen. Durch die bekannte Größe, die das Dielektrikum mit seiner stoffspezifischen Permittivitätszahl und Dicke in die Vergleichsmessung einbringt, kann das ratiometrische Messprinzip angewendet werden und, unabhängig von Kenntnissen über den Abstand vom elektrischen Leiter(con, eine elektrische Größe, insbesondere die anliegende Spannung U genau bestimmt werden. Bislang wird das Konzept der E-Feldmessung oder Spannungsmessung mittels einer Feldmühle hauptsächlich zur Messung atmosphärischer elektrischer Felder und zur Bestimmung von Potentialen in ESDgeschützten Bereichen in industriellen Umgebungen angewendet. In der vorliegenden Erfindung wird eine Umsetzung des grundlegenden Prinzips der Feldmühle in mikromechanischen Strukturen genutzt. Dadurch ergeben sich neue Anwendungsbereiche über bisherige Ansätze hinaus.

Bezugszeichenliste

D1 Detektor 1, bzw. erfasste elektrische Flussdichte
D2 Detektor 2, bzw. erfasste elektrische Flussdichte
con zu vermessender Leiter, stromführend
U zu ermittelnder Spannungswert
brd circuit board, Leiterplatte
jct leitfähige Verbindung
pot Potential, z.B. Erdung
cal Auswerteeinheit
C1 Kondensatorpaar 1
C2 Kondensatorpaar 2

**Patentansprüche**

1. Vorrichtung umfassend wenigstens eine Messeinrichtung zur Messung einer elektrischen Größe eines zu vermessenden elektrischen Leiters (con), wobei die Messeinrichtung an dem zu vermessenden elektrischen Leiter (con) galvanisch getrennt zu diesem positionierbar ist, **dadurch gekennzeichnet, dass** die wenigstens eine Messeinrichtung mit einem Dielektrikum ($\varepsilon_r$) einer bekannten Dicke ($d_\varepsilon$) angeordnet ist, so dass zwei Messungen der elektrischen Größe des zu vermessenden Leiters (con) mit unterschiedlicher Permittivität zwischen Messeinrichtung und Leiter (con) vornehmbar sind, und umfassend eine Messsignalverarbeitungseinrichtung (cal), welche ausgestaltet ist, aus den Messungen ($D_1$, $D_2$) eine weitere elektrische Größe (U) zu bestimmen.

2. Vorrichtung nach Anspruch 1, wobei die Messeinrichtung einen Sensor ($D_1$, $D_2$) zur Messung einer elektrischen Feldstärke (E) umfasst.

3. Vorrichtung nach Anspruch 2, wobei der Sensor ($D_1$, $D_2$) als mikroelektromechanische Feldmühle ausgestaltet ist.

4. Vorrichtung nach einem der vorstehenden Ansprüche, wobei die Messeinrichtung eine elektromagnetische Feldabschirmung (EMC) aufweist.

5. Vorrichtung nach einem der vorstehenden Ansprüche, wobei die Messsignalverarbeitungseinrichtung (cal) eine Auswerteelektronik umfasst.

6. Vorrichtung nach Anspruch 5, wobei die Messsignalverarbeitungseinrichtung (cal) eine Signalaufbereitung umfasst.

7. Vorrichtung nach einem der vorstehenden Ansprüche, wobei die Messeinrichtung ($D_1$) so mit einer zweiten Messeinrichtung($D_2$) nebeneinander angeordnet ist, dass beide denselben Abstand (d) zum zu vermessenden elektrischen Leiter aufweisen sowie elektrisch auf demselben Potential angeordnet sind.

8. Vorrichtung nach einem der vorstehenden Ansprüche 1 bis 6, wobei die Messeinrichtung () zwischen zwei Messpositionen beweglich angeordnet ist.

9. Vorrichtung nach einem der vorstehenden Ansprüche 1 bis 6, wobei die Messeinrichtung () mit einem beweglichen Dielektrikum angeordnet ist.

10. Vorrichtung nach einem der vorstehenden Ansprüche, wobei das Dielektrikum magnetisch, mechanisch, elektrostatisch, thermisch, optisch oder fluidisch beeinflussbar ist.

11. Vorrichtung nach einem der vorstehenden Ansprüche, wobei ein zweites Dielektrikum umfasst ist, wobei das eine Dielektrikum ein High-k-Dielektrikum und das zweite Dielektrikum ein Low-k-Dielektrikum ist.

12. Verfahren zur Bestimmung einer elektrischen Größe eines stromdurchflossenen elektrischen Leiters,

bei dem eine Vorrichtung nach einem der vorstehenden Ansprüche mit einem zu vermessenden elektrischen Leiter (con) galvanisch getrennt angeordnet wird,
bei dem eine erste und eine zweite Messungen vorgenommen werden,
bei dem in einem Messsignalverarbeitungsschritt (cal) aus den Messwerten von erster und zweiter Messung eine weitere elektrische Größe ermittelt wird.

13. Verfahren nach Anspruch 12, wobei in dem Messsignalverarbeitungsschritt (cal) die Bestimmung der weiteren elektrischen Größe ratiometrisch vorgenommen wird.

14. Verfahren nach einem der Ansprüche 12 oder 13, bei dem mittels der ersten und zweiten Messung je eine elektrische Flussdichte ($D_1$, $D_2$) erfasst wird, und bei dem im Messsignalverarbeitungsschritt (cal) die Spannung (U) bestimmt wird, wobei

$$U = \frac{D_1 D_2}{D_1 - D_2} \cdot \left( \frac{1}{\varepsilon_{r,dielect}} - \frac{1}{\varepsilon_{r,air}} \right) \frac{1}{\varepsilon_0} \cdot d_\varepsilon = \frac{D_1 D_2}{D_1 - D_2} \cdot \frac{1 - \varepsilon_r}{\varepsilon_0 \varepsilon_r} \cdot d_\varepsilon \, .$$

15. Verfahren nach Anspruch 14, bei dem die Messung der elektrischen Flussdichte (D1, D2) derart vorgenommen wird, dass mittels eines geerdeten Shutters (sh), wiederholt eine Sensorelektrodenanordnung von dem zu messenden Feld (E) abschirmt und wieder dem Feld (E) aussetzt wird, so dass die Sensorelektrodenanordnung hinter dem Shutter (sh) durch Influenz des zu messenden elektrischen Feldes (E) abwechselnd ent-und aufgeladen wird.

FIG 1

con

U

$d_0$

$\varepsilon$

$d_\varepsilon$

jct

brd

D1    cal    D2

pot

EP 4 644 919 A1

# FIG 2

# FIG 3

# FIG 4

# FIG 5

FIG 6

FIG 7

Europäisches
Patentamt

European
Patent Office

Office européen
des brevets

# EUROPÄISCHER RECHERCHENBERICHT

Nummer der Anmeldung

EP 24 17 3405

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2008/218172 A1 (USHIJIMA TAKASHI [JP] ET AL) 11. September 2008 (2008-09-11) | 1-3,5, 7-10 | INV. G01R29/12 |
| A | * Absatz [0002] - Absatz [0063]; Abbildungen 3A,3B,5A,5B,5C,8 * | 4,6 | G01R15/14 G01R15/16 |
| | ----- | | |
| X | WO 2017/168608 A1 (HITACHI SYSTEMS LTD [JP]) 5. Oktober 2017 (2017-10-05) | 1-7, 11-13 | ADD. G01R19/00 |
| A | * Ausführungsbeispiel 1; Abbildungen 1,2 * | 14,15 | |
| | ----- | | |
| A | US 2015/192885 A1 (HARA SEIJI [JP] ET AL) 9. Juli 2015 (2015-07-09) * Absätze [0078], [0079]; Abbildung 2 * | 1,4 | |
| | ----- | | |
| A | US 4 724 393 A (KUMADA AKIRA [JP] ET AL) 9. Februar 1988 (1988-02-09) * Spalte 4, Zeile 6 - Spalte 11, Zeile 37; Abbildungen 1-4,8,12 * | 1-15 | |
| | ----- | | |
| A | DE 10 2008 052477 A1 (SIEMENS AG [DE]) 10. Juni 2010 (2010-06-10) * Absatz [0001] - Absatz [0004]; Abbildung 1 * * Absatz [0017] - Absatz [0023] * | 1-15 | |
| | ----- | | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 20. September 2024 | Hof, Klaus-Dieter |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**   EP 24 17 3405

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-09-2024

| Im Recherchenbericht angeführtes Patentdokument | Datum der Veröffentlichung | Mitglied(er) der Patentfamilie | Datum der Veröffentlichung |
|---|---|---|---|
| US 2008218172 A1 | 11-09-2008 | US 2006267578 A1 | 30-11-2006 |
| | | US 2008218172 A1 | 11-09-2008 |
| WO 2017168608 A1 | 05-10-2017 | JP WO2017168608 A1 | 27-12-2018 |
| | | WO 2017168608 A1 | 05-10-2017 |
| US 2015192885 A1 | 09-07-2015 | JP 6249780 B2 | 20-12-2017 |
| | | JP 2015129845 A | 16-07-2015 |
| | | US 2015192885 A1 | 09-07-2015 |
| US 4724393 A | 09-02-1988 | KEINE | |
| DE 102008052477 A1 | 10-06-2010 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 102010035381 A1
- DE 102008052477 A1